**Europäisches Patentamt**

**European Patent Office**

**Office européen des brevets**

(11) Veröffentlichungsnummer: **0 046 549**
**B1**

(12) **EUROPÄISCHE PATENTSCHRIFT**

(45) Veröffentlichungstag der Patentschrift: **03.12.86**

(51) Int. Cl.⁴: **G 11 C 27/02, H 03 F 3/70**

(21) Anmeldenummer: **81106342.9**

(22) Anmeldetag: **14.08.81**

(54) **Ausgangsstufe einer monolithisch integrierten Ladungsverschiebeanordnung.**

(30) Priorität: **27.08.80 DE 3032332**

(43) Veröffentlichungstag der Anmeldung:
**03.03.82 Patentblatt 82/09**

(45) Bekanntmachung des Hinweises auf die
Patenterteilung:
**03.12.86 Patentblatt 86/49**

(84) Benannte Vertragsstaaten:
**AT BE CH FR GB IT LI NL SE**

(56) Entgegenhaltungen:
**US-A-3 969 636**
**US-A-4 075 509**
**US-A-4 156 818**
**US-A-4 159 430**

**IEEE J.of Sol.St.Circ., SC-10, no. 6, Dez. 1975**
**IEEE J.of Sol.St. Circ., Sc-9, no. 6, Dez. 1974**

(73) Patentinhaber: **Siemens Aktiengesellschaft**
**Berlin und München**
**Wittelsbacherplatz 2**
**D-8000 München 2 (DE)**

(72) Erfinder: **Klar, Heinrich, Dr.-Ing.**
**Rossmarkt 8**
**D-8000 München 2 (DE)**
Erfinder: **Mauthe, Manfred, Dipl.-Ing.**
**Mauthäuslstrasse 39**
**D-8000 München 70 (DE)**

Courier Press, Leamington Spa, England.

Beschreibung

Die Erfindung bezieht sich auf eine Ausgangsstufe einer monolithisch integrierten Ladungsverschiebeanordnung nach den Oberbegriffen der Ansprüche 1 oder 2.

Eine Ausgangsstufe nach dem Oberbegriff des Anspruchs 1 ist aus der US—A—4 156 818, vgl. insbesondere Fig. 9, bekannt. Hierbei ist der erste Eingang des Differenzverstärkers mit einer Abtastelektrode verbunden, die durch eine elektrisch isolierende Schicht von der Grenzfläche des Halbleiterkörpers getrennt ist. An der Abtastelektrode liegt eine konstante Spannung an, die zur Bildung einer Raumladungszone unterhalb derselben führt. Die zwischen der Abtastelektrode und der Grenzfläche des Halbleiterkörpers bestehende Isolierschichtkapazität und die Raumladungskapazität, die zusammen die Ausgangskapazität der Ladungsverschiebeanordnung bilden, werden durch die konstante Spannung an der Abtastelektrode zueinander parallel geschaltet. Da die konstante Spannung nicht unmittelbar an der Raumladungskapazität angreift, wird diese durch das Eindringen der in der Ladungsverschiebeanordnung transportierten Ladungsmengen in ihrer Größe beeinflußt. Das bedeutet, daß eine Signalabhängigkeit der Raumladungskapazität gegeben ist, die zu einer Nichtlinearität bei der Umwandlung von Ladungsmengen in Spannungssignale führt.

Andererseits ist eine Ausgangsstufe nach dem Oberbegriff des Anspruchs 2 aus der EP—A—009 100 bekannt. Dabei ist der als Inverter ausgebildete Verstärker mit einem den Ausgang der Ladungsverschiebeanordnung darstellenden Halbleitergebiet eines zu dem Halbleiterkörper entgegengesetzten Leitfähigkeitstyps verbunden. Hierbei wird die Ausgangsstufe mit einer Taktfrequenz betrieben, die kleiner ist als die Taktfrequenz, mit der die Transferelektroden beaufschlagt sind. Dadurch wird der Signal-Rausch-Abstand vergrößert. Das Problem der Nichtlinearitäten bei der Umwandlung von Ladungsmengen in ausgangsseitige Spannungssignale wird jedoch überhaupt nicht behandelt. Ein Hinweis, wie derartige Nichtlinearitäten verringert werden könnten, ist diesem Dokument daher nicht zu entnehmen.

Der Erfindung liegt die Aufgabe zugrunde, bei Ausgangsstufen der eingangs genannten Art eine möglichst lineare Umwandlung der zugeführten, signalabhängigen Ladungsmengen in Spannunssignale zu erzielen. Diese Aufgabe wird erfindungsgemäß bei einer Ausgangsstufe nach dem Oberbegriff des Anspruchs 1 durch die kennzeichnenden Merkmale desselben und bei einer Ausgangsstufe nach dem Oberbegriff des Anspruchs 2 durch die kennzeichnenden Merkmale des letzteren gelöst.

Der mit der Erfindung erzielbare Vorteil liegt insbesondere darin, daß die oben erwähnte konstante Spannung unmittelbar an die Ausgangskapazität der Ladungsverschiebeanordnung, die aus der Sperrschichtkapazität eines entgegengesetzt zu dem Halbleiterkörper dotierten Halbleitergebiets besteht, angelegt wird. Damit wird der Linearisierungsgrad bei der Umwandlung von Ladungsmengen in Spannungssignale erhöht.

Der Anspruch 3 ist auf eine bevorzugte Weiterbildung der Erfindung gerichtet.

Die Erfindung wird nachfolgend anhand der Zeichnung näher erläutert. Dabei zeigt:

Fig. 1 ein Ausführungsbeispiel der Erfindung,

Fig. 2 Spannungs-Zeit-Diagramme zur Erläuterung von Fig. 1 und

Fig. 3 eine alternative Schaltung zu einer Teilschaltung von Fig. 1.

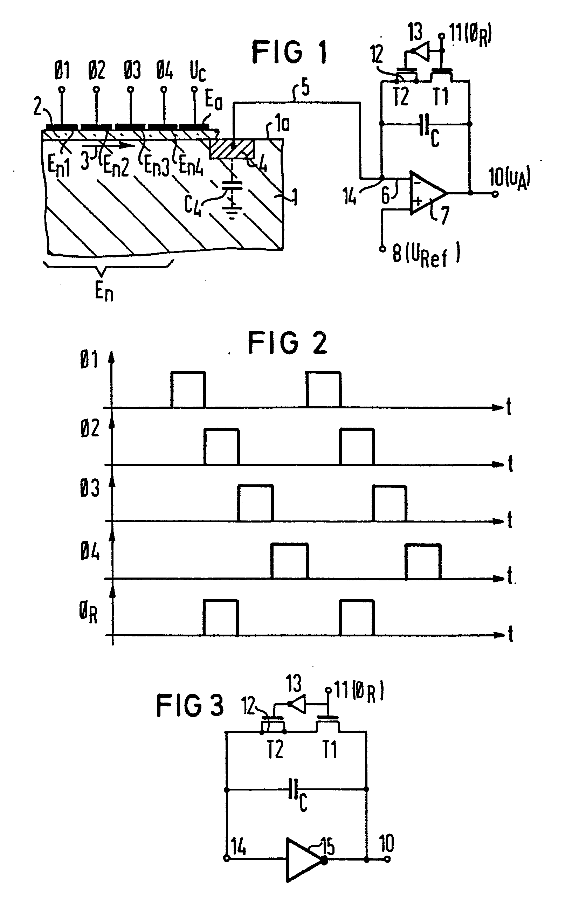

In Figur 1 ist ein Halbleiterkörper 1, z.B. aus p-dotiertem Silizium, dargestellt, auf dem eine Ladungsverschiebeanordnung (CTD) aufgebaut ist. Diese weist eine Reihe von Elementen auf, von denen jedes eine vorgegebene Anzahl von Transferelektroden enthält, die von der Grenzfläche 1a des Halbleiterkörpers 1 durch eine dünne elektrisch isolierende Schicht 2, z.B. aus $SiO_2$, getrennt sind und jeweils mit einer aus einer vorgegebenen Anzahl von gegeneinander phasenverschobenen Taktspannungen beschaltet sind. In Figur 1 wird davon ausgegangen, daß jedes Element der Ladungsverschiebeanordnung vier Transferelektroden besitzt, die mit vier gegeneinander phasenverschobenen Taktspannungen beschaltet sind. Dabei sind lediglich die zu dem letzten Element $E_n$ gehörigen Transferelektroden $E_{n1}$ bis $E_{n4}$ dargestellt, denen die Taktspannungen $\phi 1$ bis $\phi 4$ zugeführt werden. Eine Ausgangselektrode $E_a$ ist mit einer konstanten Spannung $U_c$ beschaltet, die eine Potentialschwelle unterhalb von $E_a$ erzeugt.

Ein $n^+$-dotiertes Halbleitergebiet 4, dessen Sperrschichtkapazität gegenüber dem Halbleiterkörper 1 mit $C_4$ bezeichnet ist, ist über eine Leitung 5 mit dem negativen Eingang 6 eines Differenzverstärkers 7 verbunden, dessen positiver Eingang 8 mit einer Referenzspannung $U_{Ref}$ beschaltet ist. Der Ausgang 10 des Differenzverstärkers 7, der den Schaltungsausgang darstellt, ist über eine Kapazität C mit dem Eingang 6 verbunden. Weiterhin ist die Serienschaltung zweier Feldeffekttransistoren T1 und T2 zwischen die Schaltungspunkte 6 und 10 geschaltet, sodaß sie zu C parallel liegt. Die Gateelektrode von T1 ist über einen Anschluß 11 mit einer Taktspannung $\phi_R$ belegt. Die Source-Drain-Strecke von T2 ist durch eine Verbindung 12 kurzgeschlossen, wobei die Gateelektrode von T2 mit dem Ausgang eines Inverters 13 verbunden ist, dessen Eingang an den Anschluß 11 geführt ist.

In an sich bekannter Weise wird eine Folge von negativen Ladungsmengen, die aufeinanderfolgenden Abtastwerten eines analogen Eingangssignals entsprechen, unter dem Einfluß der Taktspannungen $\phi 1$ bis $\phi 4$ (Fig. 2) in Richtung des Pfeiles 3 verschoben. Jede dieser Ladungsmengen, die sich beim Auftreten eines Impulses von $\phi 4$ gerade unterhalb von $E_{n4}$ befindet, wird beim Auftreten der rückwärtigen Flanke dieses Impulses über die Potentialschwelle unterhalb von $E_a$ in das $n^+$-dotierte Gebiet 4 transportiert.

Weist der Differenzverstärker 7 eine hinreichend große Spannungsverstärkung (z.B. v=1000) auf, so entspricht das Potential des Eingangs 6 etwa dem Potential des Eingangs 8, so daß das Gebiet 4 mit einer Spannung beschaltet ist, die etwa der Referenzspannung $U_{Ref}$ entspricht. Jede in 4 eindringende Ladungsmenge bewirkt eine entsprechende Aufladung der Kapazität C, wobei am Schaltungsausgang 10 ein der Ladungsmenge proportionales Ausgangsspannungssignal $u_A$ auftritt. Dabei wird jedoch die am Gebiet 4 liegende Spannung durch diese Ladungsmenge im eingeschwungenen Zustand nicht beeinflußt, so daß auch die Sperrschichtkapazität $C_4$ insoweit konstant bleibt. Anschließend wird T1 von einem Impuls der Spannung $\phi_R$ (Fig. 2) in den leitenden Zustand geschaltet, so daß sich die Kapazität C wieder entlädt und die Schaltung zur Auswertung der nächstfolgenden, in das Halbleitergebiet 4 transportierten Ladungsmenge vorbereittet ist. Um die vom Anschluß 11 über die Gate-Drain-Kapazität und Gate-Source-Kapazität von T1 in den Rückkopplungskreis eingekoppelten Impulsanteile von $\phi_R$ zu kompensieren, wird die invertierte Taktspannung $\overline{\phi}_R$ der Gateelektrode von T2 zugeführt. Dabei werden Impulsanteile der invertierten Taktspannung über die Gate-Drain-Kapazität und Gate-Source-Kapazität von T2 in den Rückkopplungskreis eingekoppelt, welche die über T1 eingekoppelten Impulsanteile weitgehend kompensieren.

Das Konstanthalten der am Halbleitergebiet 4 liegenden Spannung führt dazu, daß die Umwandlung der signalabhängigen Ladungsmengen in die Ausgangsspannungssignale $u_A$ sehr genau und mit einem sehr hohen Linearitätsgrad erfolgt.

Fig. 3 zeigt eine Variante zu der zwischen den Schaltungspunkten 14 und 10 liegenden Teilschaltung von Fig. 1. Hierbei wird der Differenzverstärker 7 durch einen Inverter 15 ersetzt. Der Schaltungspunkt 14 gelangt in den Entladephasen der Kapazität C, d.h. während des Auftretens der Impulse $\phi_R$, jeweils auf ein vorgegebenes Potential, das somit auch dem Halbleitergebiet 4 zugeführt wird.

Neben der bisher beschriebenen Ladungsverschiebeanordnung mit 4 Verschiebeelektroden kann die Ausgangsstufe nach der Erfindung auch bei solchen Anordnungen verwendet werden, die nach dem Zwei-, Drei- oder Mehrphasensystem arbeiten. Ebenso kann die CTD-Anordnung auch auf einem n-dotierten Halbleiterkörper aufgebaut sein, wobei dann das Halbleitergebiet 4 $p^+$-dotiert ist und die zugeführten Spannungen jeweils von entgegengesetzter Polarität sind.

## Patentansprüche

1. Ausgangsstufe einer auf einem Halbleiterkörper (1) angeordneten, monolithisch integrierten Ladungsverschiebeanordnung mit einem Verstärker (7), der einen Rückkopplungskreis mit einer über einen periodisch betätigbaren Schalter (T1) überbrückbaren Kapazität (C) aufweist, wobei der Verstärker (7) als Differenzverstärker ausgebildet ist, dessen erster Eingang (6) mit dem Ausgang der Ladungsverschiebeanordnung und dessen zweiter Eingang (8) mit einer konstanten Spanung, insbesondere mit einer Bezugsspannung, beschaltet ist, dadurch gekennzeichnet, daß der erste Eingang (6) mit einem den Ausgang der Ladungsverschiebeanordnung darstellenden Halbleitergebiet (4) des zu dem Halbleiterkörper (1) entgegengesetzten Leitfähigkeitstyps verbunden ist, dem in der Ladungsverschiebeanordnung transportiere Ladungsmengen zugeführt werden.

2. Ausgangsstufe einer auf einem Halbleiterkörper (1) angeordneten, monolithisch integrierten Ladungsverschiebeanordnung mit einem als Inverter ausgebildeten Verstärker (15), dessen Eingang mit dem Ausgang der Ladungsverschiebeanordnung verbunden ist, welcher aus einem Halbleitergebiet (4) des zu dem Halbleiterkörper (1) entgegengesetzten Leitfähigkeitstyps besteht, dadurch gekennzeichnet, daß der als Inverter ausgebildete Verstärker (15) mit einem Rückkopplungskreis versehen ist, der eine über einen periodisch betätigbaren Schalter (T1) überbrückbare Kapazität (C) aufweist.

3. Ausgangsstufe nach einem der Ansprüche 1 oder 2, dadurch gekennzeichnet, daß der Schalter aus einem Feldeffekttransistor (T1) besteht, dessen Gateelektrode mit einer Taktimpulsspannung ($\phi_R$) beschaltet ist, und daß in Serie zu der Source-Drain-Strecke dieses Feldeffekttransistors (T1) die leitend überbrückte Source-Drain-Strecke eines zweiten gleichartig aufgebauten Feldeffekttransistors (T2) angeordnet ist, dessen Gateelektrode über einen zweiten Inverter (13) mit der Gateelektrode des ersten Feldeffekttransistors (T1) verbunden ist.

## Revendications

1. Etage de sortie d'un dispositif monolithique intégré à transfert de charges, ménagé sur un corps semi-conducteur (1), comprenant un amplificateur (7) qui présente un circuit de reinjection avec une capacité (C) susceptible d'être shuntée par un interrupteur (T1) pouvant être actionné périodiquement, l'amplificateur (7) étant réalisé comme un amplificateur différentiel dont la première entrée (6) est reliée à la sortie du dispositif à transfert de charges et dont la seconde entrée (8) est soumise à une tension constante, en particulier à une tension de référence, caractérisé en ce que la première entrée (6) est connectée à une zone de semi-conducteur (4) qui représente la sortie du dispositif à transfert de charges, dont le type de conductivité est contraire à celui du corps semi-conducteur (1) et à laquelle sont amenées les quantités de charges transportées dans le dispositif à transfert de charges.

2. Etage de sortie d'un dispositif monolithique intégré à transfert de charges, aménagé sur un corps semi-conducteur (1), comprenant un amplificateur (15) réalisé comme un inverseur, dont l'entrée est reliée à la sortie du dispositif à transfert de charges, laquelle est constituée par une zone de semi-conducteur (4) ayant un type de conductivité contraire à celui du corps semi-conducteur (1), caractérisé en ce que l'amplificateur (15), réalisé comme un inverseur, est pourvu d'un circuit de réinjection qui présente une capacité (C) susceptible d'être shuntée par un interrupteur (T1) pouvant être actionné périodiquement.

3. Etage de sortie selon la revendication 1 ou 2, caractérisé en ce que l'interrupteur est constitué par un transistor à effet de champ (T1) dont l'électrode de grille est soumise à une tension impulsionnelle d'horloge ($\phi_R$) et que le circuit source-drain de ce transistor à effet de champ (T1) est branché en série avec le circuit source-drain, shunté par une liaison conductrice, d'un second transistor à effet de champ (T2), de constitution analogue, dont l'électrode de grille est reliée à travers un second inverseur (13) à l'électrode de grille du premier transistor à effet de champ (T1).

**Claims**

1. An output stage of a monolithic integrated charge transfer device arranged on a semiconductor body (1), comprising an amplifier (7) which has a feedback circuit with a capacitor (C) which can be bridged by a periodically operable switch (T1), where the amplifier (7) is in the form of a differential amplifier whose first input (6) is connected to the output of the charge transfer device and whose second input (8) is connected to a constant voltage, in particular a reference voltage, characterised in that the first input (6) is connected to a semiconductor zone (4) which represents the output of the charge transfer device, whose conductivity type is the opposite to that of the semiconductor body (1), and which is supplied with charge quantities transported in the charge transfer device.

2. An output stage of a monolithic integrated charge transfer device arranged on a semiconductor body (1), with an amplifier (15) which is in the form of an inverter and whose input is connected to the output of the charge transfer device which consists of a semiconductor zone (4) of the opposite conductivity type to that of the semiconductor body (1), characterized in that the amplifier (15), in the form of an inverter, is provided with a feedback circuit which comprises a compacitor (C) which can be bridged by a periodically operable switch (T1).

3. An output stage as claimed in one of Claims 1 or 2, characterised in that the switch consists of a field effect transistor (T1) whose gate electrode is connected to a clock pulse voltage ($\phi_R$); and that the source-drain path of this field effect transistor (T1) is arranged in series with the conductively bridged source-drain path of a second field effect transistor (T2) of identical construction whose gate electrode is connected via a second inverter (13) to the gate electrode of the first field effect transistor (T1).

FIG 1

FIG 2

FIG 3